(19) Europäisches Patentamt
European Patent Office
Office européen des brevets

(11) EP 2 533 317 A2

(12) EUROPEAN PATENT APPLICATION

(43) Date of publication:
**12.12.2012 Bulletin 2012/50**

(21) Application number: **12170848.1**

(22) Date of filing: **05.06.2012**

(51) Int Cl.:
***H01L 51/05*** *(2006.01)* ***H01L 51/00*** *(2006.01)*
***G02F 1/167*** *(2006.01)* ***C08G 73/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.06.2011 JP 2011129010**

(71) Applicant: **Ricoh Company, Ltd.**
**Tokyo 143-8555 (JP)**

(72) Inventors:
- **Tano, Takanori**
  **Tokyo 143-8555 (JP)**
- **Suzuki, Koei**
  **Tokyo 143-8555 (JP)**
- **Tsuda, Yusuke**
  **Fukuoka 830-8555 (JP)**

(74) Representative: **Schwabe - Sandmair - Marx**
**Patentanwälte**
**Stuntzstraße 16**
**81677 München (DE)**

(54) **Laminate structure, method for manufacturing a laminate structure, electronic element array, image displaying medium, image displaying apparatus, diamine, polyamic acid, and polyimide**

(57) Disclosed is a laminate structure including a substrate, a wettability changing layer (12), and an electrical conductor layer (13), wherein the wettability changing layer and the electrical conductor layer are laminated on the substrate (11) in order, wherein the wettability changing layer contains a polyimide, wherein the polyimide is obtainable by dehydrating and ring-opening a polyamic acid, wherein the polyamic acid is obtainable by ring-opening and addition-polymerizing a diamine and a tetracarboxylic acid dianhydride, wherein the diamine includes a compound represented by a general formula of:

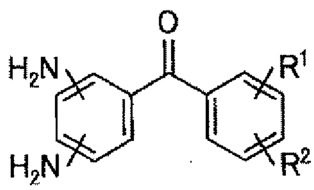

···(1)

or a compound represented by a general formula of:

EP 2 533 317 A2

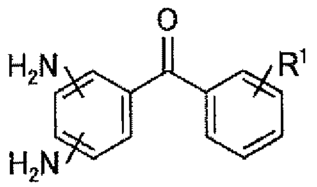

$\cdots$ (2)

, wherein each of $R^1$ and $R^2$ in formula (1) is defined in the specification, and wherein $R^1$ in formula (2) is defined in the specification.

FIG.1

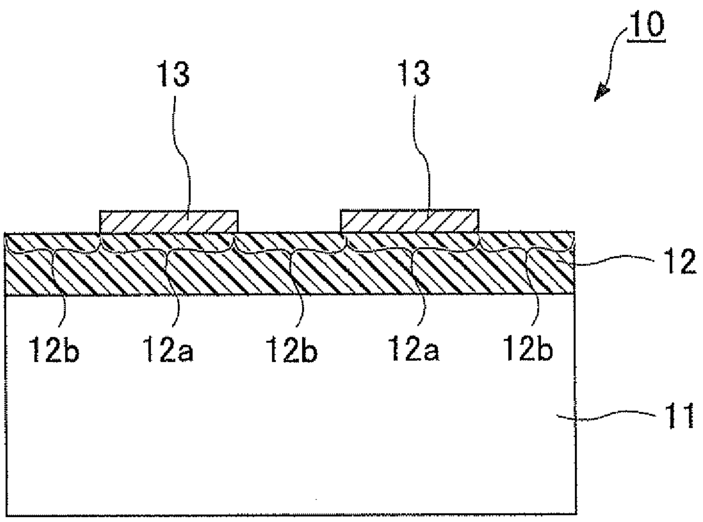

## Description

### BACKGROUND OF THE INVENTION

1. Field of the Invention

At least one aspect of the present invention relates to at least one of a laminate structure, a method for manufacturing a laminate structure, an electronic element array, an image displaying medium, an image displaying apparatus, a diamine, a polyamic acid, and a polyimide.

2. Description of the Related Art

Recently, an organic thin-film transistor using an organic semiconductor material has been studied actively. As an advantage of using an organic semiconductor material, there may be provided a high flexibility, a large surface area, a simplified manufacturing process, inexpensive manufacturing equipment, or the like.

As a parameter for indicating a characteristic of an organic thin-film transistor, an on-off ratio with respect to an electric current has been used. In an organic thin-film transistor, an on-state electric current $I_{ds}$ flowing between source and drain electrodes on a saturated area is represented by a formula of:

$$I_{ds} = \mu C_{in} W (V_G - V_{TH})^2 / 2L$$

(in the formula, $\mu$ is an electric-field-effect mobility, $C_{in}$ is a capacitance per unit area of a gate insulating film and is represented by a formula of:

$$C_{in} = \varepsilon\varepsilon_0 / d$$

(in the formula, $\varepsilon$ is a relative dielectric constant of the gate insulating film, $\varepsilon_0$ is a dielectric constant of vacuum, and d is a thickness of the gate insulating film.), W is a channel width, L is a channel length, $V_G$ is a gate voltage, and $V_{TH}$ is a threshold voltage.). From this formula, it is understood that it is effective to increase $\mu$, decrease L, or increase W in order to increase the on-state electric current. Herein, $\mu$ is largely dependent on a characteristic of an organic semiconductor material. On the other hand, L and W are dependent on a structure of an organic thin-film transistor. Additionally, a distance between source and drain electrodes is commonly decreased in order to decrease L, wherein L of 10 $\mu$m or less, and preferably 5 $\mu$m or less, may be required because $\mu$ of an organic thin-film transistor may be small.

It may be desired that such a pattern of source and drain electrodes is formed by using an ink jet printing method. As an ink jet printing method is used, it may be possible to draw a pattern directly, and therefore, an efficiency of use of a material may be high, so that it may be possible to attain simplification, and reduce a cost of, a manufacturing process. However, in an ink jet printing method, it may be difficult to make an amount of ejection small, or it may be difficult to form a pattern of 30 $\mu$m or less when a landing precision dependent on a mechanical error or the like is taken into account.

In such a situation, a method is known for forming a pattern of source and drain electrodes on a wettability changing layer using an ink jet printing method after a wettability changing layer containing a material whose surface free energy is changed due to irradiation with an ultraviolet ray is irradiated with an ultraviolet ray to change the surface free energy (for example, see Japanese Patent Application Publication No. 2008-41951).

However, it may be desired that a change of surface free energy due to irradiation with an ultraviolet ray is further increased.

Meanwhile, Japanese Patent Application Publication No. 11—140186 discloses that a change in the solubility of a polyimide thin film synthesized by using a diamine having a benzophenone structure, due to irradiation with an ultraviolet ray, is utilized to allow its application or development for a thin film or photo-resist for an electronic material capable of being patterned or the like.

### SUMMARY OF THE INVENTION

According to one aspect of the present invention, there is provided a laminate structure including a substrate, a wettability changing layer, and an electrical conductor layer, wherein the wettability changing layer and the electrical conductor layer are laminated on the substrate in order, wherein the wettability changing layer contains a polyimide,

wherein the polyimide is obtainable by dehydrating and ring-opening a polyamic acid, wherein the polyamic acid is obtainable by ring-opening and addition-polymerizing a diamine and a tetracarboxylic acid dianhydride, wherein the diamine includes a compound represented by a general formula of:

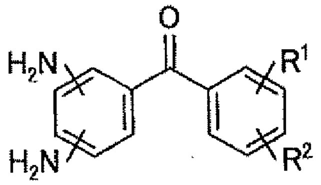

···(1)

or a compound represented by a general formula of:

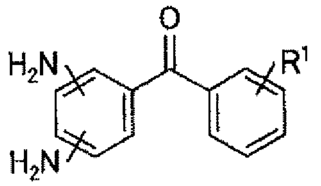

···(2)

, wherein each of $R^1$ and $R^2$ in formula (1) is independently an alkyl group with a carbon number of 6 or more and 20 or less or an alkoxy group with a carbon number of 6 or more and 20 or less, and wherein $R^1$ in formula (2) is an alkyl group with a carbon number of 6 or more and 20 or less or an alkoxy group with a carbon number of 6 or more and 20 or less.

According to another aspect of the present invention, there is provided a method for manufacturing a laminate structure, including a step of forming a wettability changing layer containing a polyimide on a substrate, a step of irradiating a predetermined area of the wettability changing layer with an ultraviolet ray, and a step of forming an electrical conductor layer on an ultraviolet-ray-irradiated area of the wettability changing layer, wherein the polyimide is obtainable by dehydrating and ring-opening a polyamic acid, wherein the polyamic acid is obtainable by ring-opening and addition-polymerizing a dimaine and a tetracarboxylic acid dianhydride, wherein the diamine includes a compound represented by a general formula of:

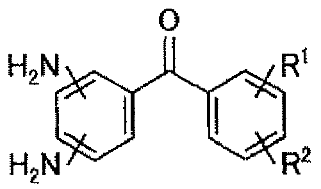

···(1)

or a compound represented by a general formula of:

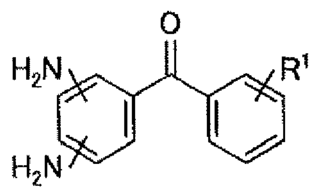

···(2)

, wherein each of $R^1$ and $R^2$ in formula (1) is independently an alkyl group with a carbon number of 6 or more and 20 or less or an alkoxy group with a carbon number of 6 or more and 20 or less, and wherein $R^1$ in formula (2) is an alkyl group with a carbon number of 6 or more and 20 or less or an alkoxy group with a carbon number of 6 or more and 20 or less.

According to another aspect of the present invention, there is provided an electronic element array including the laminate structure as described above.

According to another aspect of the present invention, there is provided an image displaying medium including the electronic element array as described above.

According to another aspect of the present invention, there is provided an image displaying apparatus including the image displaying medium as described above.

According to another aspect of the present invention, there is provided a diamine being a compound represented by a general formula of:

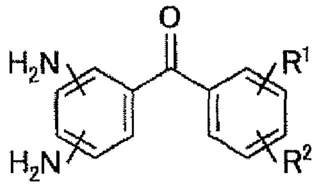

・・・(1)

, wherein each of $R^1$ and $R^2$ is independently an alkyl group with a carbon number of 6 or more and 20 or less or an alkoxy group with a carbon number of 6 or more and 20 or less.

According to another aspect of the present invention, there is provided a polyamic acid being obtainable by ring-opening and addition-polymerizing a diamine including the diamine as described above and a tetracarboxylic acid dianhydride.

According to another aspect of the present invention, there is provided a polyimide being obtainable by dehydrating and ring-opening the polyamic acid as described above.

BRIEF DESCRIPTION OF THE DRAWINGS

FIG. 1 is a cross-sectional view illustrating one example of a laminate structure according to an embodiment of the present invention.

FIG. 2A and 2B are a diagram illustrating one example of an electronic element array according to an embodiment of the present invention.

FIG. 3 is a cross-sectional view illustrating one example of an image displaying medium according to an embodiment of the present invention.

FIG. 4 is a perspective view illustrating one example of an image displaying apparatus according to an embodiment of the present invention.

FIG. 5 is a $^1H$ NMR spectrum of diamine (1).

FIG. 6 is an IR spectrum of diamine (1).

FIG. 7 is a $^1H$ NMR spectrum of polyimide (1).

FIG. 8 is a DSC thermogram of polyimide (1).

FIG. 9 is a diagram illustrating results of evaluation of contact angles for practical example 3 and comparative example 3.

DETAILED DESCRIPTION OF THE PREFERRED EMBODIMENTS

Next, an embodiment(s) for implementing the present invention will be described in conjunction with the drawings.

(A laminate structure and a method for manufacturing the same)

At least one embodiment of the present invention relates to at least one of a laminate structure, a method for manufacturing a laminate structure, an electronic element array, an image displaying medium, an image displaying apparatus, a diamine, a polyamic acid, and a polyimide.

While a problem(s) possessed by the above-mentioned conventional technique(s) may be taken into consideration, an embodiment of the present invention may aim at providing at least one of a laminate structure in which a change in its surface free energy due to irradiation with an ultraviolet ray(s) may be large, and an electronic element array, image displaying medium, and image displaying apparatus including the laminate structure.

Also, an embodiment of the present invention may aim at providing at least one of a polyimide in which a change in its surface free energy due to irradiation with an ultraviolet ray(s) may be large, a polyamic acid which may be a precursor of the polyimide, and a diamine which may be a structural unit of the polyimide.

In a laminate structure according to an embodiment of the present invention, a wettability changing layer which

contains a polyimide, and an electrical conductor layer are laminated on a substrate in order, wherein the polyimide is obtainable by dehydrating and ring-opening a polyamic acid, wherein the polyamic acid is obtainable by ring-opening and addition-polymerizing a diamine and a tetracarboxylic acid dianhydride, wherein the diamine includes a compound represented by a general formula of:

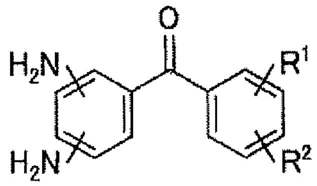

・・・(1)

(in the formula, each of $R^1$ and $R^2$ is independently an alkyl group with a carbon number of 6 or more and 20 or less or an alkoxy group with a carbon number of 6 or more and 20 or less) or a compound represented by a general formula of:

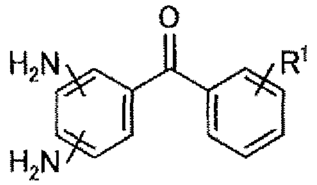

・・・(2)

(in the formula, $R^1$ is an alkyl group with a carbon number of 6 or more and 20 or less or an alkoxy group with a carbon number of 6 or more and 20 or less).

A method for manufacturing a laminate structure according to an embodiment of the present invention includes a step of forming a wettability changing layer which contains a polyimide on a substrate, a step of irradiating a predetermined area of the wettability changing layer with a ultraviolet ray(s), and a step of forming an electrical conductor layer on an ultraviolet ray irradiated area of the wettability changing layer, wherein the polyimide is obtainable by dehydrating and ring-opening a polyamic acid, wherein the polyamic acid is obtainable by ring-opening and addition-polymerizing a diamine and a tetracarboxylic acid dianhydride, wherein the diamine includes a compound represented by a general formula of:

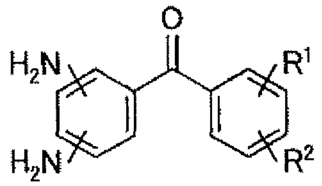

・・・(1)

(in the formula, each of $R^1$ and $R^2$ is independently an alkyl group with a carbon number of 6 or more and 20 or less or an alkoxy group with a carbon number of 6 or more and 20 or less) or a compound represented by a general formula of:

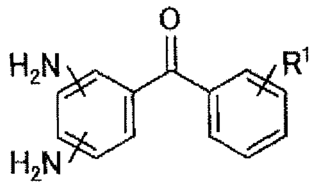

・・・(2)

(in the formula, $R^1$ is an alkyl group with a carbon number of 6 or more and 20 or less or an alkoxy group with a carbon number of 6 or more and 20 or less).

An electronic element array according to an embodiment of the present invention includes the laminate structure according to an embodiment of the present invention.

An image displaying medium according to an embodiment of the present invention includes the electronic

element array according to an embodiment of the present invention.

An image displaying apparatus according to an embodiment of the present invention includes the image displaying medium according to an embodiment of the present invention.

A diamine according to an embodiment of the present invention is a compound represented by a general formula of:

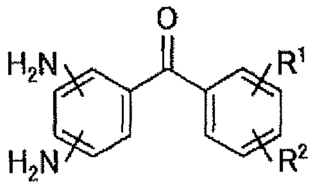

...(1)

(in the formula, each of $R^1$ and $R^2$ is independently an alkyl group with a carbon number of 6 or more and 20 or less or an alkoxy group with a carbon number of 6 or more and 20 or less).

A polyamic acid according to an embodiment of the present invention is obtainable by ring-opening and addition-polymerizing a diamine which includes the diamine according to an embodiment of the present invention, and a tetracarboxylic acid dianhydride.

A polyimide according to an embodiment of the present invention is obtainable by dehydrating and ring-opening the polyamic acid according to an embodiment of the present invention.

According to at least one embodiment of the present invention, it may be possible to provide at least one of a laminate structure in which a change in its surface free energy due to irradiation with an ultraviolet ray(s) may be large, and an electronic element array, image displaying medium, and image displaying apparatus including the laminate structure.

Also, according to at least one embodiment of the present invention, it may be possible to provide at least one of a polyimde in which a change in its surface free energy due to irradiation with an ultraviolet ray(s) may be large, a polyamic acid which may be a precursor of the polyimide, and a diamine which may be a structural unit of the polyimide.

FIG. 1 illustrates one example of a laminate structure according to an embodiment of the present invention. For a laminate structure 10, a wettability changing layer 12 containing a polyimide according to an embodiment of the present invention is formed on a substrate 11. Herein, the wettability changing layer 12 is composed of ultraviolet ray irradiated areas 12a whose surface free energy has been increased by irradiation with ultraviolet rays and ultraviolet ray non-irradiated areas 12b which have not been irradiated with ultraviolet rays. Additionally, the ultraviolet ray non-irradiated area 12b with a width of 1 - 5 μm is formed between the ultraviolet ray irradiated areas 12a. Furthermore, electrical conductor layers 13 are formed on the ultraviolet ray irradiated areas 12a of the wettability changing layer 12, so as to provide a laminate structure. Thereby, it may be possible to readily form the electrical conductor layers 13 having a fine pattern.

A material constituting the substrate 11 is not particularly limited and there may be provided a glass; a resin such as a polyester, a polycarbonate, a polyacrylate, a polyether sulfone, a polyethylene terephthalate, or a polyethylene naphthalate; a metal such as SUS; or the like, wherein a resin may be preferable if flexibility is required.

A polyimide according to an embodiment of the present invention includes one which is obtainable by dehydrating and ring-opening a polyamic acid according to an embodiment of the present invention while using a publicly-known method and has a remaining part of amide linkages thereof. Furthermore, a polyamic acid according to an embodiment of the present invention is obtainable by ring-opening and addition-polymerizing a diamine including a diamine according to an embodiment of the present invention and a tetracarboxylic acid dianhydride while using a publicly-known method.

A diamine according to an embodiment of the present invention is a compound represented by general formula (1).

Herein, each of an alkyl group and an alkoxy group for any of $R^1$ and $R^2$ may be linear or may be branched. Furthermore, each of an alkyl group and an alkoxy group for any of $R^1$ and $R^2$ may include a cycloalkyl group or a cycloalkylene group.

If a carbon number of at least one of an alkyl group and an alkoxy group for any of $R^1$ and $R^2$ is 1 - 5, a change in the surface free energy of the wettability changing layer 12 due to irradiation with ultraviolet rays may be insufficient, and if it is 21 or more, a solubility of a polyimide according to an embodiment of the present invention in an aprotic and polar organic solvent may be insufficient.

A method for synthesizing a diamine according to an embodiment of the present invention will be described below.

A method for synthesizing diamine (1) represented by a chemical formula of:

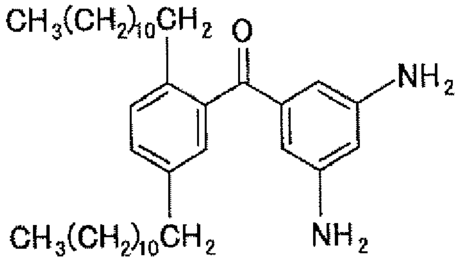

will be described, wherein $R^1$ and $R^2$ in general formula (1) are n-dodecyl groups.

First, 1,4-didodecylbenzene represented by a chemical formula of:

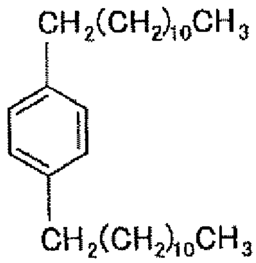

and 3,5-dinitrobenzoyl chloride represented by a chemical formula of:

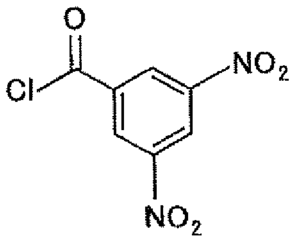

are subjected to electrophilic substitution to obtain a dinitro body (1) represented by a chemical formula of:

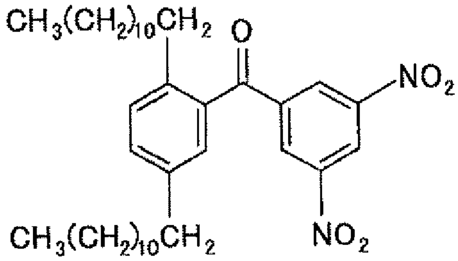

. Then, dinitro body (1) is subjected to catalytic reduction to obtain diamine (1).

Next, a method for synthesizing diamine (2) represented by a chemical formula of:

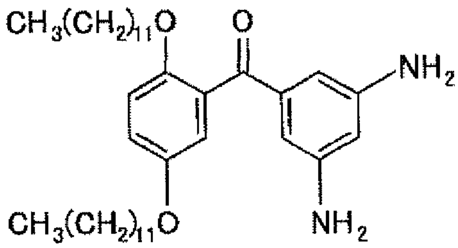

will be described, wherein $R^1$ and $R^2$ in general formula (1) are n-dodekoxy groups.

First, a dipotassium salt of hydroquinone represented by a chemical formula of:

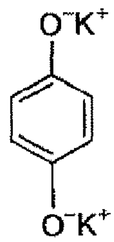

and 1-bromododecane are subjected to nucleophilic substitution to obtain an ether body (1) represented by a chemical formula of:

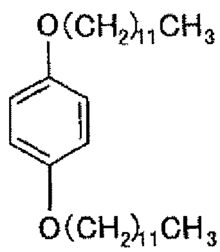

- Then, ether body (1) and 3,5-dinitrobenzoyl chloride are subjected to electrophilic substitution to obtain a dinitro body (2) represented by a chemical formula of:

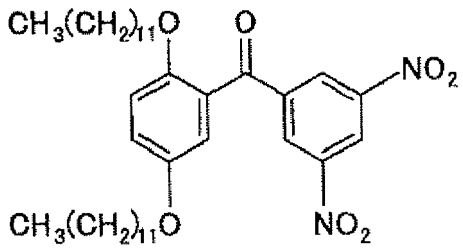

- Furthermore, dinitro body (2) is subjected to catalytic reduction to obtain diamine (2).

Preferably, a diamine to be used for synthesizing a polyamic acid according to an embodiment of the present invention may further contain an aromatic and cyclic diamine other than a diamine according to an embodiment of the present invention.

The aromatic and cyclic diamine is not particularly limited and there may be provided p-phenylenediamine, 4,4-methylenediamine, 4,4'-oxydianiline, m-bis(aminophenoxy)diphenyl sulfone, p-bis(aminophenoxy)diphenyl sulfone, 2,2-bis[(aminophenoxy)phenyl]propane, 2,2-bis[(aminophenoxy)phenyl]hexafluoropropane, or the like, wherein two or more kinds thereof may be used in combination.

Furthermore, the diamine may further include a diaminosiloxane represented by a general formula of:

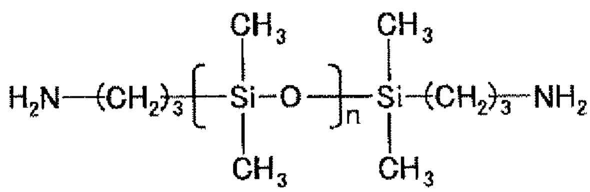

(in the formula, n is an integer of 1 - 10) in place of the aromatic and cyclic diamine or in combination with the aromatic and cyclic diamine.

A molar ratio of a diamine according to an embodiment of the present invention based on a total amount of the

diamine may be usually 0.1 - 0.7 and preferably 0.2 — 0.5. If a molar ratio of a diamine according to an embodiment of the present invention based on a total amount of the diamine is less than 0.1, a change of a surface free energy of the wettability changing layer 12 due to irradiation with an ultraviolet ray(s) may be insufficient, and if it is greater than 0.7, a solubility of a polyimide according to an embodiment of the present invention in an aprotic and polar organic solvent may be insufficient.

Preferably, a tetracarboxylic acid dianhydride to be used for synthesizing a polyamic acid according to an embodiment of the present invention may include an alicyclic tetracarboxylic acid dianhydride.

The alicyclic tetracarboxylic acid dianhydride is not particularly limited and there may be provided 5-(2,5-dioxotetrahydrofuryl)-3-methylcyclohexene-1,2-dicarboxylic acid dianhydride, bicyclooctene-2,3,5,6-tetracarboxylic acid dianhydride, 1,2,3,4-cyclobutanetetracarboxylic acid dianhydride, 1,2,3,4-cyclopentanetetracarboxylic acid dianhydride, 1,2,4,5-cyclohexanetetracarboxylic acid dianhydride, or the like, wherein two or more kinds thereof may be used in combination.

Furthermore, the tetracarboxylic acid dianhydride may include an aromatic and cyclic tetracarboxylic acid dianhydride in place of the alicyclic tetracarboxylic acid dianhydride or in combination with the alicyclic tetracarboxylic acid dianhydride.

The aromatic and cyclic tetracarboxylic acid dianhydride is not particularly limited and there may be provided pyromellitic acid dianhydride, biphthalic acid dianhydride, oxydiphthalic acid dianhydride, benzophenonetetracarboxylic acid dianhydride, hexafluoroisopropylidenediphthalic acid dianhydride, or the like, wherein two or more kinds thereof may be used in combination.

A molar ratio of an alicyclic tetracarboxylic acid dianhydride based on a total amount of the tetracarboxylic acid dianhydride may be usually 0.2 - 1.0 and preferably 0.5 - 1. If a molar ratio of an alicyclic tetracarboxylic acid dianhydride based on a total amount of the tetracarboxylic acid dianhydride is less than 0.2, an insulating property of the wettability changing layer 12 may be degraded due to irradiation with an ultraviolet ray(s).

Preferably, a number-average molecular weight of a polyamic acid according to an embodiment of the present invention may be $5 \times 10^3$ - $5 \times 10^5$. Accordingly, it may be possible for a glass transition point of a polyimide according to an embodiment of the present invention to be 200 - 350 °C.

Herein, the number-average molecular weight is a molecular weight in terms of polystyrene which is measured by using a GPC (gel permeation chromatography).

It may be possible to form the wettability changing layer 12 by applying to the substrate 11 an application fluid in which a polyamic acid according to an embodiment of the present invention is dissolved in an aprotic and polar organic solvent and subsequently dehydrating and ring-opening such a polyamic acid according to an embodiment of the present invention.

The aprotic and polar organic solvent is not particularly limited and there may be provided N-methyl-2-pyrolidone, γ-butyrolactone, dimethylformamide, dimethylacetamide, tetrahydrofuran, or the like.

A method for applying an application fluid to the substrate 11 is not particularly limited and there may be provided a dip coat method, a spin coat method, a transfer printing method, a roll coat method, an ink jet method, a spray method, a brush coating method, or the like.

A rate of reaction of dehydrating and ring-opening of a polyamic acid according to an embodiment of the present invention may be preferably 90 - 100% and more preferably 95 - 100%. If the rate of reaction is less than 90%, it may not be possible to form a good interface between the wettability changing layer 12 and an organic semiconductor layer when the wettability changing layer 12 is used as a gate insulating film of an organic thin-film transistor. Accordingly, a variation of a threshold voltage of such an organic thin-film transistor may increase.

Herein, it may be possible to measure the rate of reaction by dissolving a polyimide in dimethylsulfoxide (DMSO) - $d_6$ to measure $^1$HNMR thereof and calculating a ratio of a remaining amide linkage(s) from a ratio of peak surface areas therein.

Preferably, a polyimide according to an embodiment of the present invention may be soluble in an aprotic and polar organic solvent. In such a case, it may be possible to form the wettability changing layer 12 by applying to the substrate 11 an application fluid in which a polyimide according to an embodiment of the present invention is dissolved in an aprotic and polar solvent. Herein, the application fluid may further contain a polyamic acid according to an embodiment of the present invention.

The wettability changing layer 12 includes a polyimide according to an embodiment of the present invention which has an alkyl group or an alkoxy group in a side chain thereof so as to be hydrophobic and have a smaller surface free energy.

Meanwhile, when the wettability changing layer 12 is irradiated with an ultraviolet ray(s), it is considered that a polyimide according to an embodiment of the present invention may be photo-dissociated so as to be hydrophilic, that is, to have a larger surface free energy. When a polyimide according to an embodiment of the present invention is photo-dissociated, a radical may be generated and a generated radical may immediately react with moisture contained in atmosphere so as to produce a carboxylic group or a hydroxyl group.

Additionally, the wettability changing layer 12 may contain a polyimide identical to a polyimide according to an embodiment of the present invention in place of the polyimide according to an embodiment of the present invention or in combination with the polyimide according to an embodiment of the present invention except that a compound represented by general formula (2) is used in place of a diamine according to an embodiment of the present invention.

Herein, an alkyl group and alkoxy group for $R^1$ in a compound represented by general formula (2) are similar to an alkyl group and alkoxy group for $R^1$ in a compound represented by general formula (1), respectively.

Furthermore, the wettability changing layer 12 may further contain an insulating resin.

The insulating resin is not particularly limited and there may be provided a polyimide, a polyamideimide, an epoxy resin, a silsesquioxane, a polyvinylphenol, a polycarbonate, a fluororesin, a poly(p-xylylene), or the like.

Furthermore, the wettability changing layer 12 may further contain a film-forming resin.

A thickness of the wettability changing layer 12 may be usually 30 nm - 3 $\mu$m and preferably 50 nm - 1 $\mu$m. If a thickness of the wettability changing layer 12 is less than 30 nm, uniform formation thereof may be difficult, and if it is greater than 3 $\mu$m, a surface shape thereof may be degraded.

It may be possible to form the electrical conductor layer 13 by applying, and subsequently heating or irradiating with an ultraviolet ray(s), an application fluid containing an electrically conductive material.

The electrically conductive material is not particularly limited and there may be provided a metal such as gold, silver, copper, aluminum, or calcium; a carbon material such as a carbon black, a fullerene, or a carbon nanotube; an organic $\pi$-conjugate polymer such as a polythiophene, a polyaniline, a polypyrrole, a polyfluorene, or a derivative thereof; or the like, wherein two or more kinds thereof may be used in combination. Additionally, when a gate electrode and source and drain electrodes are formed, electrically conductive materials different from one another may be used.

The application fluid containing an electrically conductive material is not particularly limited and there may be provided a solution in which an electrically conductive material or a precursor thereof is dissolved in a solvent, a dispersion fluid in which an electrically conductive material or a precursor thereof is dispersed in a solvent, or the like.

The solvent is not particularly limited, and there may be provided water, each kind of alcohol, or the like because damage to the wettability changing layer 12 may be small. Furthermore, it may also be possible to use a solvent such as N,N-dimethylformamide, N,N-dimethylacetamide, 2-pyrolidone, N-methyl-2-pyrolidone, N-ethyl-2-pyrolidone, N-vinyl-2-pyrolidone, N-methylcaprolactam, dimethyl sulfoxide, or tetramethylurea, as long as damage to the wettability changing layer 12 may be small.

For the application fluid containing an electrically conductive material, there may be provided a dispersion fluid in which a particle(s) of a metal such as silver, gold, nickel, or copper is/are dispersed in an organic solvent or water, an aqueous solution of a doped PANI (polyaniline), an aqueous solution of an electrically conductive polymer in which a PEDOT (polyethylenedioxythiophene) is doped with a PSS (polystyrenesulfonic acid), or the like.

A method for applying the application fluid containing an electrically conductive material is not particularly limited and there may be provided a spin coat method, a dip coat method, a screen printing method, an offset printing method, an ink jet method, or the like. Among these, an ink jet method may be preferable because of susceptibleness to influence of a surface free energy of the wettability changing layer 12.

Although the resolution and landing precision of a normal ink jet head at a level to be used in an ink jet printer are about 30 $\mu$m and about $\pm$ 15 $\mu$m, respectively, it may be possible to form the electrical conductor layer 13 having a fine pattern by utilizing a difference between surface free energies of the wettability changing layer 12.

It may be possible to apply a laminate structure according to an embodiment of the present invention to a gate electrode and its wiring of an organic thin-film transistor, source and drain electrodes and their wiring thereof, or the like.

FIGS. 2A and 2B illustrate a thin-film transistor array as one example of an electronic element array according to an embodiment of the present invention. A thin-film transistor array 30 has a plurality of bottom-gate-type thin-film transistors 20. Herein, FIG. 2A and 2B are a cross-sectional view and top view thereof, respectively. Furthermore, an identical reference numeral is provided for an element in FIG. 2A and 2B which is identical to that of FIG. 1 and an explanation thereof will be omitted.

For the thin-film transistor 20, gate electrodes 21 are formed on a substrate 11. Furthermore, wettability changing layers 12 as gate insulating films are formed on the substrate 11 on which the gate electrodes 21 are formed, and electrical conductor layers 13 as source and drain electrodes are formed on ultraviolet-ray-irradiated areas of the wettability changing layers 12. Moreover, semiconductor layers 22 are formed on channel areas between the source and drain electrodes. Thus, it may be possible to readily form gate electrodes and source and drain electrodes having a fine pattern.

The semiconductor layer 22 may be any of an inorganic semiconductor layer and an organic semiconductor layer, wherein an organic semiconductor layer may be preferable because it may be possible to simplify, or reduce the cost of, a process for manufacturing a thin-film transistor.

A material for composing the inorganic semiconductor layer is not particularly limited and there may be provided CdSe, CdTe, Si, or the like.

A method for forming the inorganic semiconductor layer is not particularly limited and there may be provided

a method using a vacuum process such as sputtering, a sol-gel method, or the like.

A material for composing the organic semiconductor layer is not particularly limited and there may be provided a low molecule such as pentacene, anthracene, tetracene, or phthalocyanine; a polyacetylene-type electrically conductive polymer; a polyphenylene-type electrically conductive polymer such as a poly(p-phenylene) or a derivative thereof or a polyphenylenevinylene or a derivative thereof; a heterocyclic electrically coinductive polymer such as a polypyrrole or a derivative thereof, a polythiophene or a derivative thereof, or a polyfuran or a derivative thereof; an ionic electrically conductive polymer such as a polyaniline or a derivative thereof; or the like.

A method for forming the orranic semiconductor layer is not particularly limited and there may be provided a spin coat method, a spray coat method, a printing method, an ink jet method, or the like.

Additionally, wettability changing layers 12 may be formed a substrate 11 in place of forming of the gate electrodes 21, and electrical conductor layers 13 as gate electrodes may be formed on ultraviolet-ray-irradiated areas of the wettability changing layers 12.

Herein, polyimides according to an embodiment of the present invention which are contained in two of the wettability changing layers 12 may be identical to or may be different from each other. Furthermore, electrically conductive materials which are contained in two of the electrical conductor layers 13 may be identical to or may be difficult from each other.

Meanwhile, when volume resistivities of the wettability changing layers 12 are small, insulator layers with volume resistivities greater than those of the wettability changing layers 12 and the wettability changing layers 12 may be laminated in order so as to form gate insulating films. When such gate insulating films are irradiated with ultraviolet rays, it may be possible to suppress degradation of insulating properties of the insulator layers because the wettability changing layers 12 may absorb ultraviolet rays.

A material for composing the insulator layer is not particularly limited and there may be provided a polyimide, a polyamideimide, an epoxy resin, a silsesquioxane, a polyvinylphenol, a polycarbonate, a fluororesin, a poly(p-xylylene), or the like.

A method for forming the insulator layer is not particularly limited and there may be provided a transfer printing method, a spin coat method, a dip coat method, or the like.

FIG. 3 illustrates an electrophoretic panel as one example of an image displaying medium according to an embodiment of the present invention. For an electrophoretic panel 40, a transparent electrode 42 is formed on a transparent substrate 41, and an image displaying layer 43 composed of microcapsules 43a as electrophoretic elements and a binder 43b is formed on the electrode 42. Herein, the microcapsule 43a encapsulates, for example, white titanium oxide particles and Isopar L (produced by Exxon Mobil Chemical) colored with oil blue. Furthermore, the image displaying layer 43 is connected to a thin-film transistor array 30 as an active matrix substrate.

Additionally, an image displaying medium according to an embodiment of the present invention is not limited to an electrophoretic panel but may be a liquid crystal panel or organic EL panel in which an active matrix substrate is combined with an image displaying element such as a liquid crystal element or organic EL element, or the like. Furthermore, it may be possible to use an image displaying medium according to an embodiment of the present invention as an electronic paper.

Herein, it may also be possible to apply a polyimide according to an embodiment of the present invention to a liquid crystal alignment film in a liquid crystal element or a bank in an organic EL element, other than a laminate structure.

FIG. 4 illustrates a pocket PC as one example of an image displaying apparatus according to an embodiment of the present invention. A pocket PC has an electrophoretic panel 40 as a flat screen on which an image is displayed by inputting image information from input parts 51.

Additionally, it may be possible to apply an electronic element array according to an embodiment of the present invention to a solar cell, an RFID tag, or the like, other than an image displaying medium.

Furthermore, it may be possible to apply an image displaying medium according to an embodiment of the present invention to a copying machine or the like, other than an image displaying apparatus, and it may also be possible to be embedded in a seat part or front glass surface of a moving or transportation medium such as an automobile or an airplane, or the like.

[Practical example 1]

(Synthesis of diamine)

After 1 g of 1,4-didodecylbenzene, 0.61 g of 3,5-dinitrobenzoyl chloride, and nitromethane were charged into a two-necked flask and cooled to 10 °C or lower in an ice-water bath, 1.6 g of aluminum chloride was dropped therein while stirring was conducted. Then, heating and refluxing were conducted at 100 °C for 24 hours, and subsequently cooling to room temperature was conducted. Furthermore, a small amount of dichloromethane was added thereto, so as to dissolve a precipitated product, and subsequently, an oil phase was washed and dried under vacuum so as to

obtain dinitro body (1).

After 3.48 g of dinitro body (1) was charged into a pressure bottle, ethanol and tetrahydrofuran were added thereto. Then, a small amount of palladium on carbon was added thereto, and subsequently, catalytic reduction was conducted by using a catalytic reduction apparatus for about 2 hours. Furthermore, the palladium on carbon was removed, and subsequently, drying under vacuum was conducted. An obtained product was purified on a column to obtain diamine (1).

FIGS. 5 and 6 illustrate a $^1$H NMR spectrum and IR spectrum of diamine (1), respectively.

(Synthesis of polyamic acid)

After 0.5 mol of diamine (1) and 0.5 mol of a diamine represented by a chemical formula of:

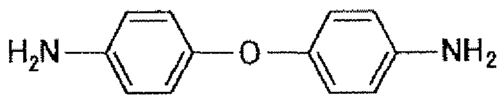

were charged into a container, N-methyl-2-pyrolidone was added thereto, so as to be dissolved therein. Then, 1 mol of a tetracarboxylic acid dianhydride represented by a chemical formula of:

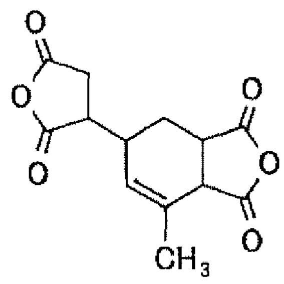

was dropped thereto under argon atmosphere while stirring was conducted, and ring-opening and addition polymerization was conducted at room temperature for 24 hours so as to obtain polyamic acid (1) represented by a chemical formula of:

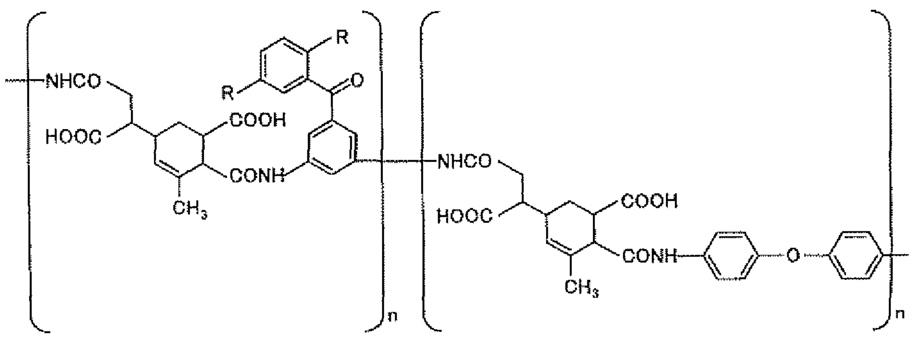

(R= $CH_2(CH_2)_{10}CH_3$ )

. A number-average molecular weight of polyamic acid (1) was 5500.

(Synthesis of polyimide)

After N-methyl-2-pyrolidone was added to polyamic acid (1), pyridine and acetic anhydride were added thereto and dehydration and ring-opening were conducted at 120 °C under argon atmosphere for 4 hours. After an obtained reaction fluid was dropped into stirred methanol to provide a precipitate, filtration under reduced pressure and drying under vacuum were conducted so as to obtain polyimide (1) represented by a chemical formula of:

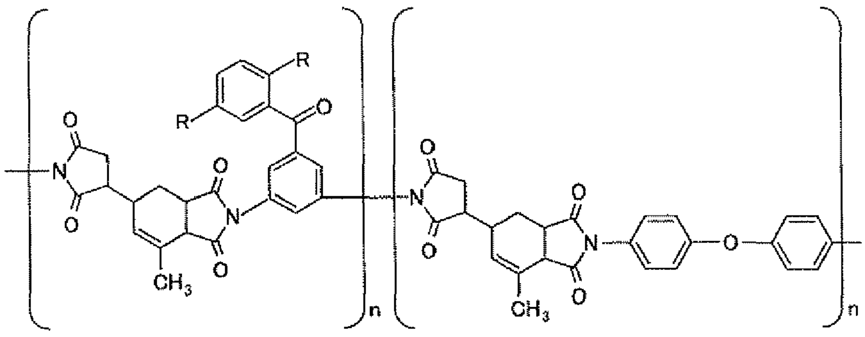

(R= $CH_2(CH_2)_{10}CH_3$)

FIGS. 7 and 8 illustrate a $^1$H NMR spectrum and DSC thermogram of polyimide (1), respectively.

(Contact angle)

After a 10% by mass solution of polyimide (1) in N-methyl-2-pyrolidone was applied onto a substrate 11 made of an inorganic alkali glass by using a spin coat method, baking at 200 °C under an inert gas atmosphere was conducted by using an oven so as to form a wettability changing layer 12 with a thickness of 100 nm.

After the wettability changing layer 12 was irradiated with ultraviolet rays with a wavelength of 254 nm by using a high pressure mercury lamp, a contact angle of a dispersion fluid in which silver nanoparticles were dispersed in an aqueous dispersion medium (referred to as a silver nanoink, below) was measured by a liquid drop method. The results of the measurement are presented in Table 1.

(Patterning characteristic)

After a 10% by mass solution of polyimide (1) in N-methyl-2-pyrolidone was applied onto a substrate 11 made of an inorganic alkali glass by using a spin coat method, baking at 200 °C under an inert gas atmosphere was conducted by using an oven so as to form a wettability changing layer 12 with a thickness of 100 nm. Then, the wettability changing layer 12 was irradiated with ultraviolet rays with a wavelength of 254 nm by using a high pressure mercury lamp through a photomask having line shapes with a spacing of 5 μm. Furthermore, after the silver nanoink was applied onto an ultraviolet-ray-irradiated area by using an ink jet method, baking at 200 °C under an inert gas atmosphere was conducted by using an oven so as to form an electrical conductor layer 13 and obtain a laminate structure 10 (see FIG. 1).

The electrical conductor layer 13 was observed by using a metallurgical microscope so as to evaluate a patterning characteristic thereof. The results of the evaluation are presented in Table 1. Herein, judgment was conducted such that "A", "B", and "C" were provided for 90% or greater, 10% or greater and less than 90%, and less than 10% of the electrical conductor layer 13 having line shapes with a spacing of 5 μm having been formed, respectively.

[Practical example 2]

(Synthesis of diamine)

After 10 g of hydroquinone, 75.31 g of potassium carbonate, and N,N-dimethylformamide were charged into a three-necked flask and heated in an oil bath at 70 °C under argon atmosphere, 45 g of 1-bromododecane was dropped thereto while stirring was conducted, and stirring was conducted at 70 °C for 24 hours. Then, cooling to room temperature was conducted, and subsequently, a reaction fluid was thrown into deionized water so as to provide a precipitate. Furthermore, the precipitate was filtered, and subsequently, washing operations were repeated. Then, recrystallization was conducted with a mixed liquid of ethyl acetate and ethanol, and subsequently, drying under vacuum was conducted so as to obtain ether body (1).

After 1 g of ether body (1), 0.61 g of 3,5-dinitrobenzoyl chloride, and carbon disulfide were charged into a two-necked flask and cooled to 10 °C or lower in an ice-water bath, 1.6 g of aluminum chloride was dropped thereto while stirring was conducted. Then, heating and refluxing were conducted at 40 °C for 24 hours, and subsequently, cooled to room temperature. Furthermore, after a reaction fluid was quenched with a mixed liquid of ice water and hydrochloric acid, an oil phase was washed with deionized water and an aqueous solution of sodium hydroxide by using a separating funnel and dried under vacuum so as to obtain dinitro body (2).

Diamine (2) was obtained similarly to practical example 1 except that dinitro body (2) was used in place of

dinitro body (1).

(Synthesis of polyamic acid)

Polyamic acid (2) represented by a chemical formula of:

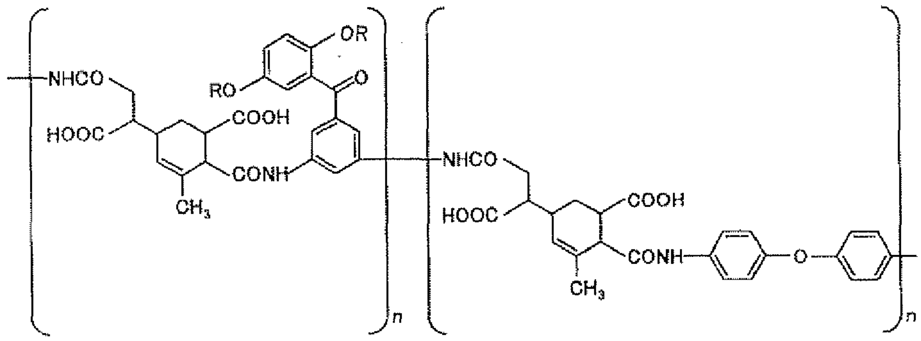

(R= $(CH_2)_{11}CH_3$)

was obtained similarly to practical example 1 except that diamine (2) was used in place of diamine (1). A number-average molecular weight of polyamic acid (2) was 6500.

(Synthesis of polyimide)

Polyimide (2) represented by a chemical formula of:

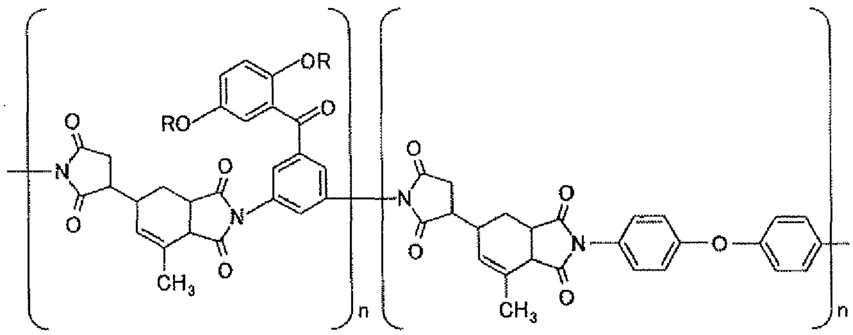

(R= $(CH_2)_{11}CH_3$)

was obtained similarly to practical example 1 except that polyamic acid (2) was used in place of polyamic acid (1).

(Contact angle)

A contact angle of a silver nanoink was measured similarly to practical example 1 except that a 10% by mass solution of polyimide (2) in γ-butyrolactone was used in place of a 10% by mass solution of polyimide (1) in N-methyl-2-pyrolidone. The results of the measurement are presented in Table 1.

(Patterning characteristic)

A patterning characteristic was evaluated similarly to practical example 1 except that a 10% by mass solution of polyimide (2) in γ-butyrolactone was used in place of a 10% by mass solution of polyimide (1) in N-methyl-2-pyrolidone. The results of the measurement are presented in Table 1.

[Comparative example 1]

(Synthesis of polyamic acid)

A polyamic acid was obtained similarly to practical example 1 except that a diamine represented by a chemical formula of:

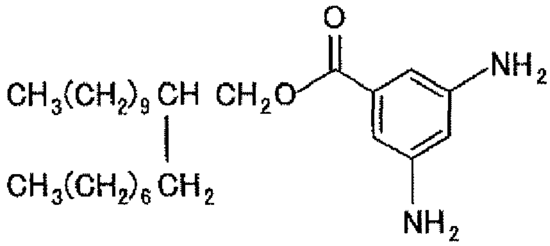

was used in place of diamine (1). A number-average molecular weight of the polyamic acid was 10000.

(Synthesis of polyimide)

A polyimide was obtained similarly to practical example 1 except that the obtained polyamic acid was used in place of polyamic acid (1).

(Contact angle)

A contact angle of a silver nanoink was measured similarly to practical example 1 except that a 10% by mass solution of the obtained polyimide in N-methyl-2-pyrolidone was used in place of a 10% by mass solution of polyimide (1) in N-methyl-2-pyrolidone. The results of the measurement are presented in Table 1.

(Patterning characteristic)

A patterning characteristic was evaluated similarly to practical example 1 except that a 10% by mass solution of the obtained polyimide in N-methyl-2-pyrolidone was used in place of a 10% by mass solution of polyimide (1) in N-methyl-2-pyrolidone. The results of the measurement are presented in Table 1.

[Comparative example 2]

(Synthesis of polyamic acid)

A polyamic acid was obtained similarly to practical example 1 except that a diamine represented by a chemical formula of:

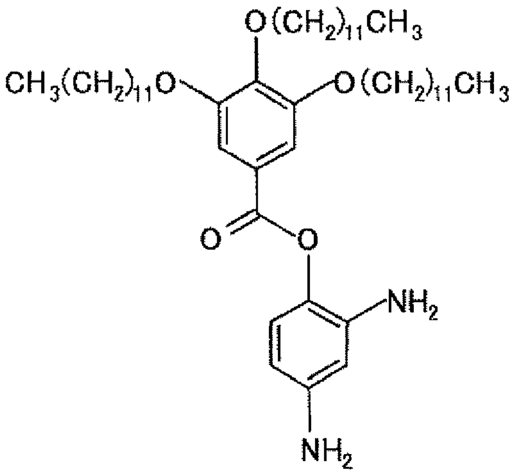

was used in place of diamine (1). A number-average molecular weight of the polyamic acid was 9000.

(Synthesis of polyimide)

A polyimide was obtained similarly to practical example 1 except that the obtained polyamic acid was used in place of polyamic acid (1).

(Contact angle)

A contact angle of a silver nanoink was measured similarly to practical example 1 except that a 10% by mass solution of the obtained polyimide in N-methyl-2-pyrolidone was used in place of a 10% by mass solution of polyimide (1) in N-methyl-2-pyrolidone. The results of the measurement are presented in Table 1.

(Patterning characteristic)

A patterning characteristic was evaluated similarly to practical example 1 except that a 10% by mass solution of the obtained polyimide in N-methyl-2-pyrolidone was used in place of a 10% by mass solution of polyimide (1) in N-methyl-2-pyrolidone. The results of the measurement are presented in Table 1.

Table 1

| | Amount of ultraviolet ray irradiation [J/cm$^2$] | 0 | 1 | 2 | 3 | 5 |
|---|---|---|---|---|---|---|
| Practical example 1 | Contact angle [°] | 33 | 13 | 5 | 5 | 4 |
| | Patterning characteristic | C | B | A | A | A |
| Practical example 2 | Contact angle [°] | 32 | 12 | 5 | 5 | 4 |
| | Patterning characteristic | C | B | A | A | A |
| Comparative example 1 | Contact angle [°] | 26 | 21 | 17 | 15 | 6 |
| | Patterning characteristic | C | C | C | B | A |
| Comparative example 2 | Contact angle [°] | 35 | 29 | 24 | 14 | 9 |
| | Patterning characteristic | C | C | C | B | B |

It was found from Table 1 that when the wettability changing layer 12 for practical example 1 was irradiated with 2 J/cm$^2$ of ultraviolet rays with a wavelength of 254 nm, polyimide (1) was photo-dissociated and accordingly the contact angle of the silver nanoink decreased from 33° to 5°.
Also, it was found that when the wettability changing layer 12 for practical example 2 was irradiated with 2 J/cm$^2$ of ultraviolet rays with a wavelength of 254 nm, polyimide (2) was photo-dissociated and accordingly the contact angle of the silver nanoink decreased from 32° to 5°.
On the other hand, it was found that even when the wettability changing layer for comparative example 1 was irradiated with 5 J/cm$^2$ of ultraviolet rays with a wavelength of 254 nm, the contact angle of the silver nanoink only decreased from 26° to 6°.
Also, it was found that even when the wettability changing layer for comparative example 2 was irradiated with 5 J/cm$^2$ of ultraviolet rays with a wavelength of 254 nm, the contact angle of the silver nanoink only decreased from 35° to 9°.
As a result, it was found that a change of a surface free energy of the wettability changing layer 12 for practical example 1 or 2 due to irradiation with ultraviolet rays with a wavelength of 254 nm was greater than that of the wettability changing layer for comparative example 1 or 2.
Also, it was found from Table 1 that the results of evaluation of the patterning characteristic correlated with the results of evaluation of a change of the contact angle.

[Practical example 3]

(Synthesis of polyamic acid)

Polyamic acid (3) represented by a chemical formula of:

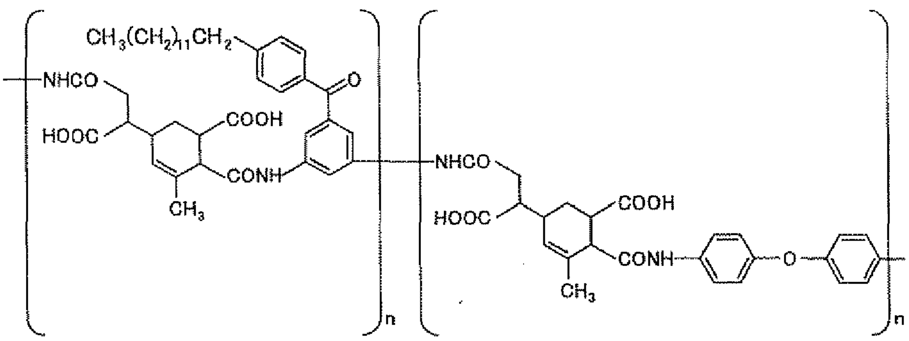

was obtained similarly to practical example 1 except that diamine (3) represented by a chemical formula of:

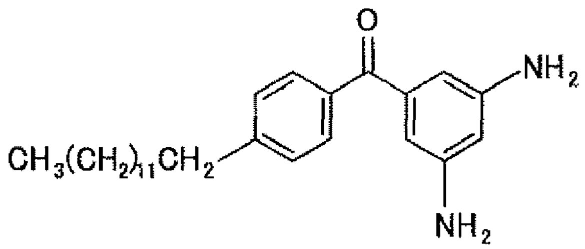

was used in place of diamine (1). A number-average molecular weight of polyamic acid (3) was 6000.

(Synthesis of polyimide)

Polyimide (3) represented by a chemical formula of:

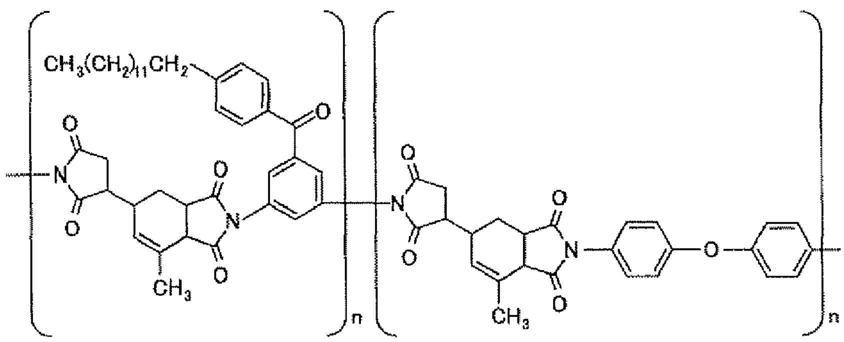

was obtained similarly to practical example 1 except that polyamic acid (3) was used in place of polyamic acid (1).

(Contact angle)

A contact angle of a silver nanoink was measured similarly to practical example 1 except that a 10% by mass solution of polyimide (3) in N-methyl-2-pyrolidone was used in place of a 10% by mass solution of polyimide (1) in N-methyl-2-pyrolidone. The results of the measurement are illustrated in FIG. 9.

(Patterning characteristic)

A patterning characteristic was evaluated similarly to practical example 1 except that a 10% by mass solution of polyimide (3) in N-methyl-2-pyrolidone was used in place of a 10% by mass solution of polyimide (1) in N-methyl-2-pyrolidone. The results of the evaluation are presented in Table 2.

[Comparative example 3]

(Synthesis of polyamic acid)

A polyamic acid was obtained similarly to practical example 1 except that a diamine represented by a chemical formula of:

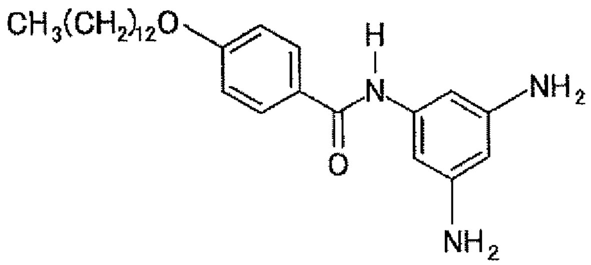

was used in place of diamine (1). A number-average molecular weight of the polyamic acid was 7000.

(Synthesis of polyimide)

A polyimide was obtained similarly to practical example 1 except that the obtained polyamic acid was used in place of polyamic acid (1).

(Contact angle)

A contact angle of a silver nanoink was measured similarly to practical example 1 except that a 10% by mass solution of the obtained polyimide in N-methyl-2-pyrolidone was used in place of a 10% by mass solution of polyimide (1) in N-methyl-2-pyrolidone. The results of the measurement are illustrated in FIG. 9.

(Patterning characteristic)

A patterning characteristic was evaluated similarly to practical example 1 except that a 10% by mass solution of the obtained polyimide in N-methyl-2-pyrolidone was used in place of a 10% by mass solution of polyimide (1) in N-methyl-2-pyrolidone. The results of the evaluation are presented in Table 2.

Table 2

| Amount of ultraviolet ray irradiation [J/cm$^2$] | 0 | 1 | 2 | 5 | 9 |
|---|---|---|---|---|---|
| Practical example 3 | C | A | A | — | — |
| Comparative example 3 | C | C | C | B | A |

It was found from FIG. 9 that when the wettability changing layer 12 for practical example 3 was irradiated with 2 J/cm$^2$ of ultraviolet rays with a wavelength of 254 nm, polyimide (3) was photo-dissociated and accordingly the contact angle of the silver nanoink decreased from 25° to 5°.

On the other hand, it was found that when the wettability changing layer for comparative example 3 was irradiated with 9 J/cm$^2$ of ultraviolet rays with a wavelength of 254 nm, the contact angle of the silver nanoink decreased from 28° to 5°.

As a result, it was found that a surface free energy of the wettability changing layer 12 for practical example 3 was changed with an amount of ultraviolet ray irradiation lower than that for the wettability changing layer for comparative example 3.

Also, it was found from FIG. 9 and Table 2 that the results of evaluation of the patterning characteristic correlated with the results of evaluation of a change of the contact angle.

[Manufacturing of thin-film transistor array 1]

After aluminum was deposited under vacuum by using a metal mask so that gate electrodes 21 with a thickness

of 50 nm were formed on a substrate 11 made of a glass, gate insulating films having a thickness of 500 nm and being composed of parylene were formed on the substrate 11 on which the gate electrodes 21 had been formed. Then, a solution of polyimide (3) for practical example 3 in N-methyl-2-pyrolidone was applied onto the substrate 11 on which the gate insulating films had been formed, by using a spin coat method, and subsequently, baking at 200 °C under an inert gas atmosphere was conducted by using an oven so as to form wettability changing layers 12 with a thickness of 100 nm. Furthermore, the wettability changing layers 12 were irradiated with 1 J/cm$^2$ of ultraviolet rays with a wavelength of 254 nm through a photomask by using a high pressure mercury lamp. Then, the silver nanoink was applied onto ultraviolet-ray-irradiated areas by using an ink jet method, and subsequently, baking at 200 °C under an inert gas atmosphere was conducted by using an oven so as to form electrical conductor layers 13 (source electrodes and drain electrodes with a channel length of 5 μm). Furthermore, a solution of a compound represented by a chemical formula of:

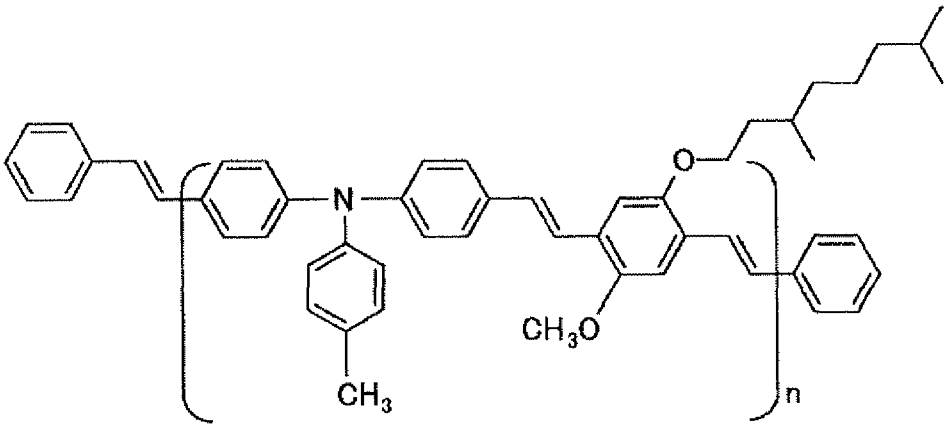

in xylylene was applied onto channel areas between the source electrodes and the drain electrodes by using a micro-contact print method, and subsequently, heating at 100 °C was conducted by using an oven so as to form semiconductor layers 22 with a thickness of 30 nm and obtain a thin-film transistor array 1 (see FIG. 2A and 2B). The thin-film transistor array 1 has 32 × 32 thin-film transistors 20 with a spacing of 500 μm.

[Manufacturing of thin-film transistor array 2]

After a solution of polyimide (3) for practical example 3 in N-methyl-2-pyrolidone was applied onto a substrate 11 made of an inorganic alkali glass by using a spin coat method, baking at 180 °C under an inert gas atmosphere was conducted by using an oven so as to form wettability changing layers with a thickness of 80 nm. Then, the wettability changing layers were irradiated with 1 J/cm$^2$ of ultraviolet rays with a wavelength of 254 nm through a photomask by using a high pressure mercury lamp. Furthermore, the silver nanoink was applied onto ultraviolet-ray-irradiated areas by an ink jet method, and subsequently, baking at 180 °C under an inert gas atmosphere was conducted by using an oven so as to form gate electrodes 21. Then, a solution of polyimide (3) for practical example 3 and polyimide CT4112 (produced by KYOCERA Chemical Corporation) in N-methyl-2-pyrolidone was applied by using a spin coat method, and subsequently, baking at 180 °C under an inert gas atmosphere was conducted by using an oven so as to form wettability changing layers 12 (gate insulating films) with a thickness of 800 nm. Furthermore, the wettability changing layers 12 were irradiated with 1 J/cm$^2$ of ultraviolet rays with a wavelength of 254 nm through a photomask by using a high pressure mercury lamp. Then, the silver nanoink was applied onto ultraviolet-ray-irradiated areas by using an ink jet method, and subsequently, baking at 150 °C under an inert gas atmosphere was conducted by using an oven so as to form electrical conductor layers 13 (source electrodes and drain electrodes with a channel length of 5 μm). Furthermore, semiconductor layers 22 with a thickness of 30 nm were formed on channel areas between the source electrodes and the drain electrodes similarly to thin-film transistor array 1, so as to obtain thin-film transistor array 2. Thin-film transistor array 2 has 32 × 32 thin-film transistors 20 with a spacing of 500 μm.

[Manufacturing of thin-film transistor array 3]

Thin-film transistor 3 was obtained similarly to thin-film transistor array 1 except that the solution of the polyimide for comparative example 3 in N-methyl-2-pyrolidone was used in place of the solution of polyimide (3) for practical example 3 in N-methyl-2-pyrolidone and wettability changing layers were irradiated with 9 J/cm$^2$ of ultraviolet rays with a wavelength of 254 nm.

The results of evaluation of transistor characteristics of the thin-film transistor arrays are presented in Table 3.

Table 3

| Thin-film transistor array | Polyimide | Amount of ultraviolet ray irradiation [J/cm$^2$] | Electric-field-effect mobility [cm$^2$/V·sec] | On-off ratio |
|---|---|---|---|---|
| 1 | Practical example 3 | 1 | $5 \times 10^{-3}$ | 5 digits |
| 2 | Practical example 3 | 1 | $2 \times 10^{-3}$ | 5 digits |
| 3 | Comparative example 3 | 9 | $1 \times 10^{-4}$ | 3 digits |

It was found from Table 3 that thin-film transistor array 1 or 2 had a larger electric-field-effect mobility as well as a smaller gate leak electric current and a larger on-off ratio.

On the other hand, thin-film transistor array 3 had a smaller electric-field-effect mobility as well as a larger gate leak electric current and a smaller on-off ratio. It was considered that this was because an amount of irradiation of the ultraviolet rays with a wavelength of 254 nm was greater.

[Manufacturing of electrophoretic panel]

An electrophretic panel (see FIG. 3) was manufactured by using thin-film transistor array 2. Specifically, an application fluid in which microcapsules 43a encapsulating titanium oxide particles and Isopar colored with oil blue and an aqueous solution of a polyvinyl alcohol 43b were mixed was applied onto transparent electrodes made of ITO 42 and formed on a transparent substrate 41 made of a polycarbonate so as to form an image displaying layer 43 composed of microcapsules 43a and a polyvinyl alcohol 43b. Furthermore, the image displaying layer 43 and the thin-film transistor array 30 were bonded such that the substrate 11 and the transparent substrate 41 had outermost surfaces, thereby obtaining an electrophoretic panel 40.

When a driver IC for scanning signals was connected to bus lines which were interconnected to gate electrodes 21 of the electrophoretic panel 40 while a driver IC for data signals was connected to bus lines which were interconnected to source electrodes and switching between images was conducted every 0.5 seconds, it was possible to display good static images.

[Appendix]

Some illustrative embodiments (1) to (12) of the present invention will be described below.

Embodiment (1) is a laminate structure characterized in that a wettability changing layer containing a polyimide and an electrical conductor layer are laminated on a substrate in order, wherein the polyimide is obtainable by dehydrating and ring-opening a polyamic acid, wherein the polyamic acid is obtainable by ring-opening and addition-polymerizing a diamine and a tetracarboxylic acid dianhydride, wherein the diamine includes a compound represented by a general formula of:

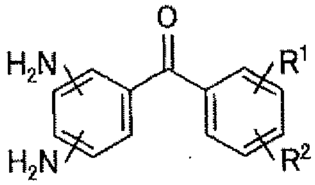

・・・(1)

(in the formula, each of $R^1$ and $R^2$ is independently an alkyl group with a carbon number of 6 or more and 20 or less or an alkoxy group with a carbon number of 6 or more and 20 or less.) or a compound represented by a general formula of:

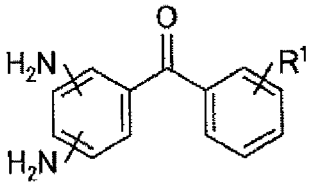

・・・(2)

(in the formula, $R^1$ is an alkyl group with a carbon number of 6 or more and 20 or less or an alkoxy group with a carbon number of 6 or more and 20 or less.).

Embodiment (2) is the laminate structure as recited in embodiment (1), characterized in that the diamine further includes an aromatic and cyclic diamine.

Embodiment (3) is the laminate structure as recited in embodiment (1) or (2), characterized in that the tetracarboxylic acid dianhydride includes an alicyclic tetracarboxylic acid dianhydride.

Embodiment (4) is the laminate structure as recited in any one of embodiments (1) to (3), characterized in that a number-average molecular weight of the polyamic acid is $5 \times 10^3$ or greater and $5 \times 10^5$ or less.

Embodiment (5) is a method for manufacturing a laminate structure, characterized by including a step of forming a wettability changing layer containing a polyimide on a substrate, a step of irradiating a predetermined area of the wettability changing layer with an ultraviolet ray, and a step of forming an electrical conductor layer on an ultraviolet-ray-irradiated area of the wettability changing layer, wherein the polyimide is obtainable by dehydrating and ring-opening a polyamic acid, wherein the polyamic acid is obtainable by ring-opening and addition-polymerizing a dimaine and a tetracarboxylic acid dianhydride, wherein the diamine includes a compound represented by a general formula of:

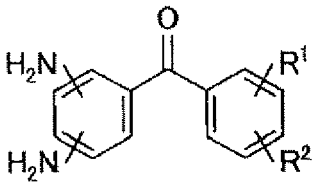

・・・(1)

(in the formula, each of $R^1$ and $R^2$ is independently an alkyl group with a carbon number of 6 or more and 20 or less or an alkoxy group with a carbon number of 6 or more and 20 or less.) or a compound represented by a general formula of:

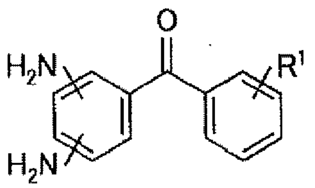

・・・(2)

(in the formula, $R^1$ is an alkyl group with a carbon number of 6 or more and 20 or less or an alkoxy group with a carbon number of 6 or more and 20 or less.).

Embodiment (6) is the method for manufacturing a laminate structure as recited in embodiment (5), characterized in that an application fluid containing the polyimide and/or polyamic acid having a solubility is applied onto the substrate to form the wettability changing layer.

Embodiment (7): An electronic element array characterized by including the laminate structure as recited in any one of embodiments (1) to (4).

Embodiment (8) is an image displaying medium characterized by including the electronic element array as recited in embodiment (7).

Embodiment (9) is an image displaying apparatus characterized by including the image displaying medium as recited in embodiment (8).

Embodiment (10) is a diamine characterized by being a compound represented by a general formula of:

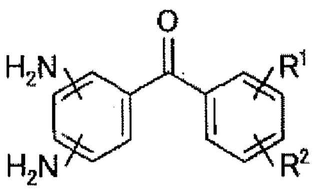

··· (1)

(in the formula, each of $R^1$ and $R^2$ is independently an alkyl group with a carbon number of 6 or more and 20 or less or an alkoxy group with a carbon number of 6 or more and 20 or less.).

Embodiment (11) is a polyamic acid characterized by being obtainable by ring-opening and addition-polymerizing a diamine including the diamine recited in embodiment (10) and a tetracarboxylic acid dianhydride.

Embodiment (12) is a polyimide characterized by being obtainable by dehydrating and ring-opening the polyamic acid as recited in embodiment (11).

Although the illustrative embodiment(s) and specific example(s) of the present invention have been described with reference to the accompanying drawing(s), the present invention is not limited to any of the illustrative embodiment (s) and specific example(s), and the illustrative embodiment(s) and specific example(s) may be altered, modified, or combined without departing from the scope of the present invention.

The present application claims the benefit of its priority based on Japanese patent application No. 2011-129010 filed on June 9, 2011, the entire content of which is hereby incorporated by reference herein.

## Claims

**1.** A laminate structure **characterized by** comprising:

a substrate;
a wettability changing layer; and
an electrical conductor layer;
wherein the wettability changing layer and the electrical conductor layer are laminated on the substrate in order;
wherein the wettability changing layer contains a polyimide;
wherein the polyimide is obtainable by dehydrating and ring-opening a polyamic acid;
wherein the polyamic acid is obtainable by ring-opening and addition-polymerizing a diamine and a tetracarboxylic acid dianhydride;
wherein the diamine includes a compound represented by a general formula of:

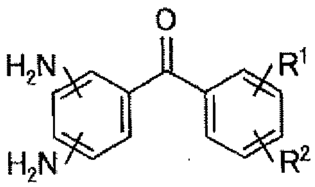

··· (1)

or a compound represented by a general formula of:

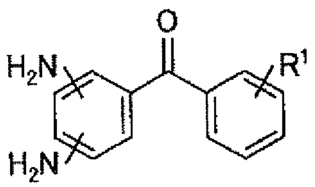

··· (2)

;
wherein each of $R^1$ and $R^2$ in formula (1) is independently an alkyl group with a carbon number of 6 or more and 20 or less or an alkoxy group with a carbon number of 6 or more and 20 or less; and
wherein $R^1$ in formula (2) is an alkyl group with a carbon number of 6 or more and 20 or less or an alkoxy group

with a carbon number of 6 or more and 20 or less.

**2.** The laminate structure according to claim 1, wherein the diamine further includes an aromatic and cyclic diamine.

**3.** The laminate structure according to claim 1 or 2, wherein the tetracarboxylic acid dianhydride includes an alicyclic tetracarboxylic acid dianhydride.

**4.** The laminate structure according to any one of claims 1 to 3, wherein a number-average molecular weight of the polyamic acid is $5 \times 10^3$ or greater and $5 \times 10^5$ or less.

**5.** A method for manufacturing a laminate structure, **characterized by** comprising:

a step of forming a wettability changing layer containing a polyimide on a substrate;
a step of irradiating a predetermined area of the wettability changing layer with an ultraviolet ray; and
a step of forming an electrical conductor layer on an ultraviolet-ray-irradiated area of the wettability changing layer;
wherein the polyimide is obtainable by dehydrating and ring-opening a polyamic acid;
wherein the polyamic acid is obtainable by ring-opening and addition-polymerizing a dimaine and a tetracarboxylic acid dianhydride;
wherein the diamine includes a compound represented by a general formula of:

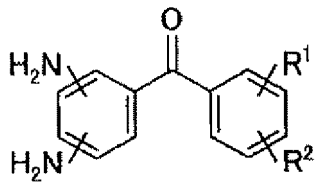

・・・(1)

or a compound represented by a general formula of:

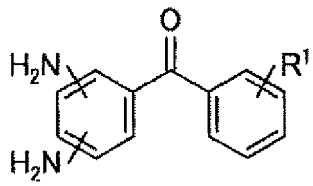

・・・(2)

;
wherein each of $R^1$ and $R^2$ in formula (1) is independently an alkyl group with a carbon number of 6 or more and 20 or less or an alkoxy group with a carbon number of 6 or more and 20 or less; and
wherein $R^1$ in formula (2) is an alkyl group with a carbon number of 6 or more and 20 or less or an alkoxy group with a carbon number of 6 or more and 20 or less.

**6.** The method for manufacturing a laminate structure according to claim 5, wherein an application fluid containing the polyimide and/or polyamic acid having a solubility is applied onto the substrate to form the wettability changing layer.

**7.** An electronic element array **characterized by** comprising the laminate structure according to any one of claims 1 to 4.

**8.** An image displaying medium **characterized by** comprising the electronic element array according to claim 7.

**9.** An image displaying apparatus **characterized by** comprising the image displaying medium according to claim 8.

**10.** A diamine **characterized by** being a compound represented by a general formula of:

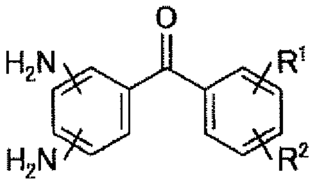

・・・(1)

, wherein each of $R^1$ and $R^2$ is independently an alkyl group with a carbon number of 6 or more and 20 or less or an alkoxy group with a carbon number of 6 or more and 20 or less.

**11.** A polyamic acid **characterized by** being obtainable by ring-opening and addition-polymerizing a diamine including the diamine according to claim 10 and a tetracarboxylic acid dianhydride.

**12.** A polyimide **characterized by** being obtainable by dehydrating and ring-opening the polyamic acid according to claim 11.

FIG.1

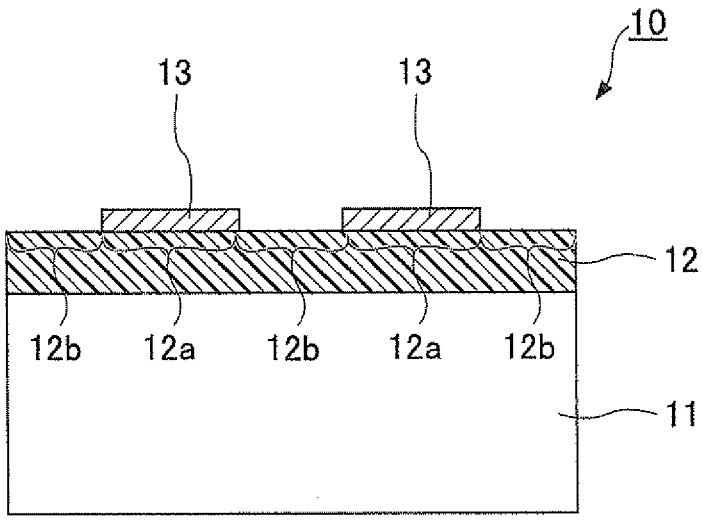

FIG.2A

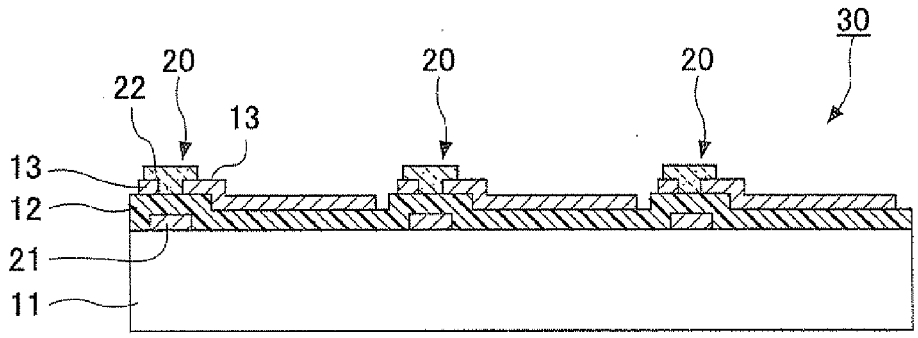


FIG.2B

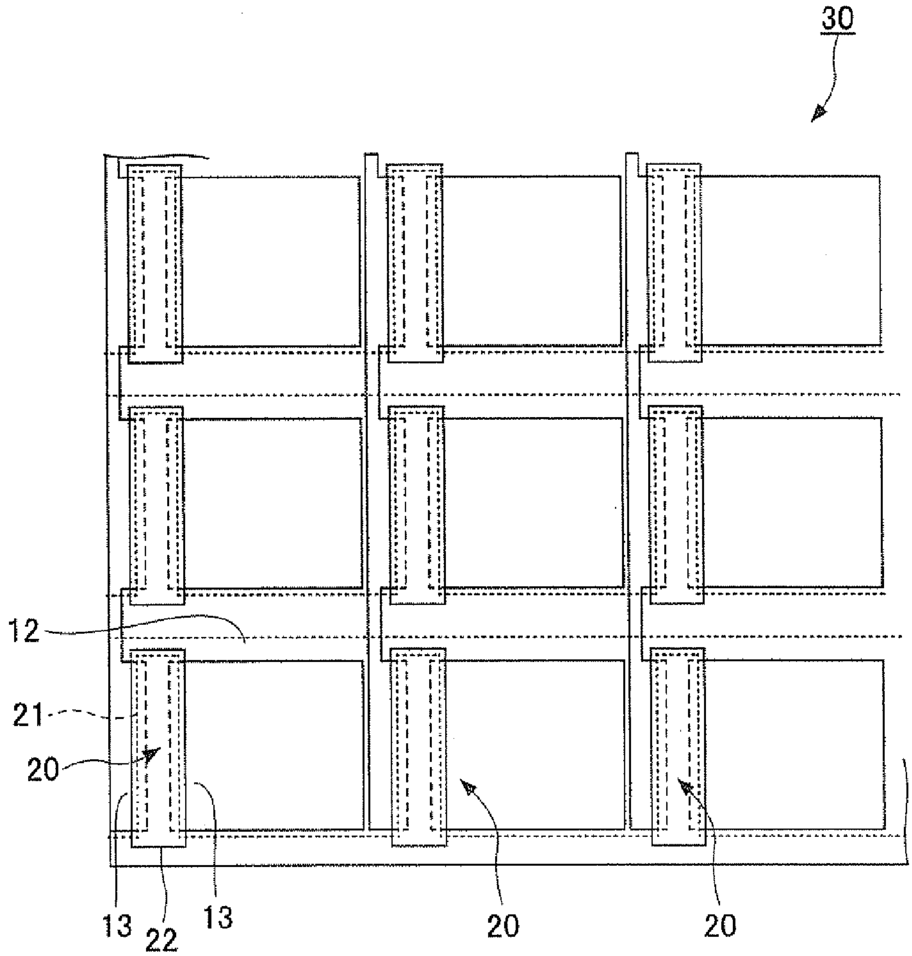

FIG.3

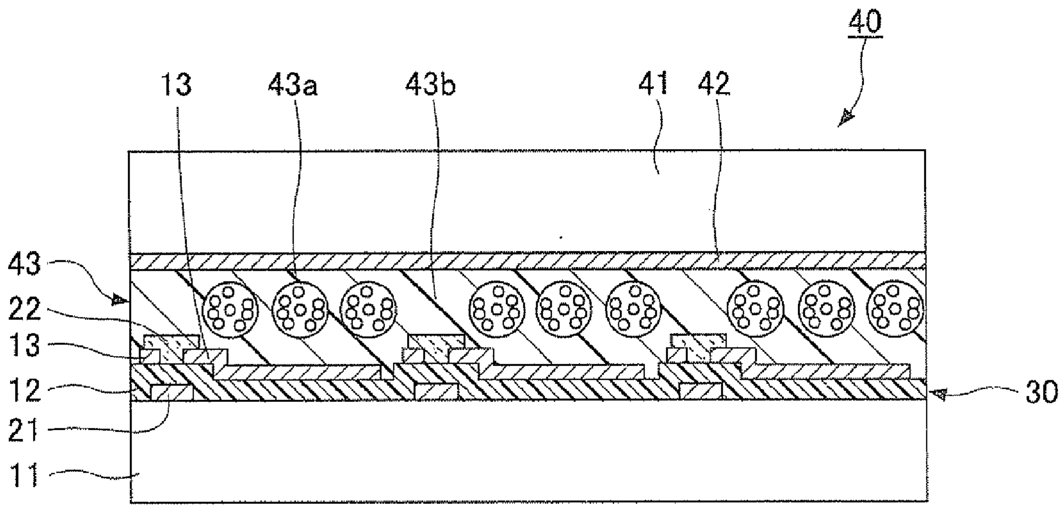


FIG.4

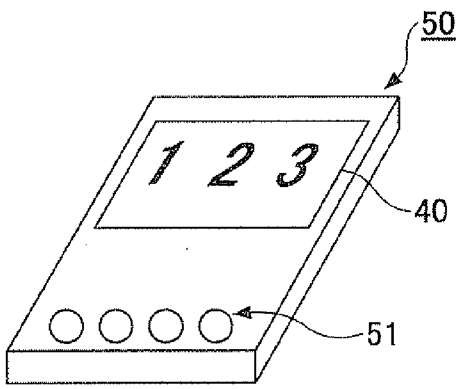

FIG.5

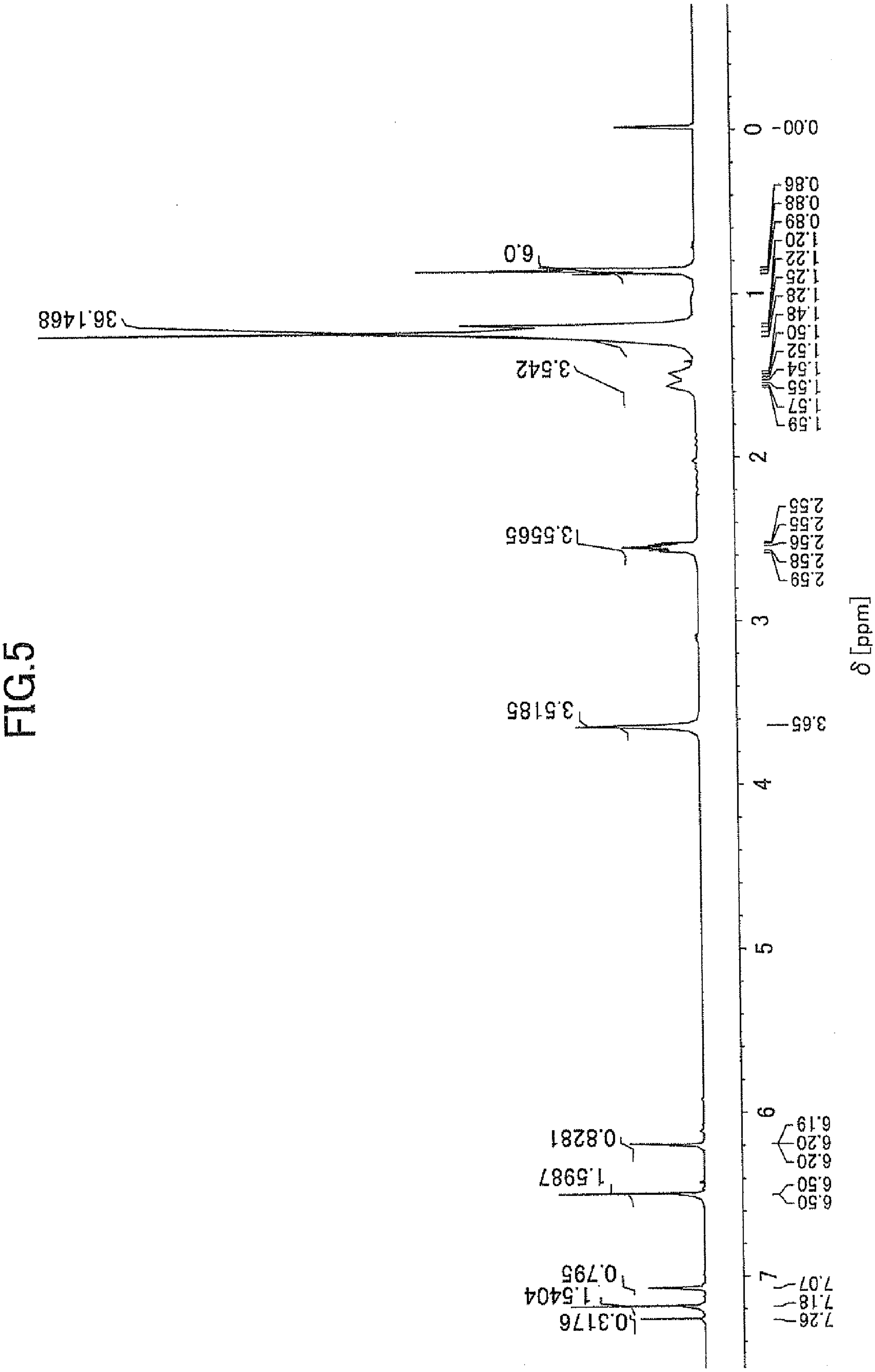
36.14468
6.0
3.542
3.5565
3.5185
0.8281
1.5987
0.795
1.5404
0.3176
0.00
0.86
0.88
0.89
1.20
1.22
1.25
1.28
1.48
1.50
1.52
1.54
1.55
1.57
1.59
2.55
2.55
2.56
2.58
2.59
3.65
6.19
6.20
6.20
6.50
6.50
7.07
7.18
7.26
0
1
2
3
4
5
6
7
δ [ppm]

FIG.6

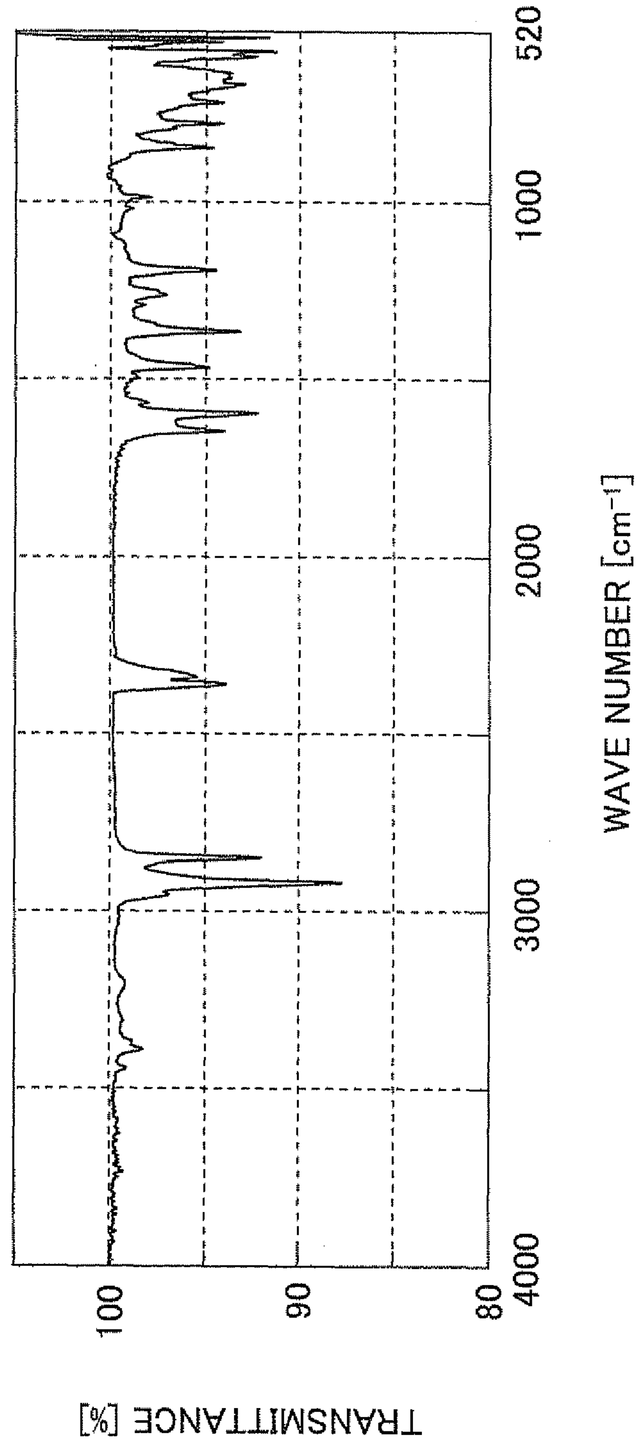
TRANSMITTANCE [%]
100
90
80
4000
3000
2000
1000
520
WAVE NUMBER [$cm^{-1}$]

FIG.7

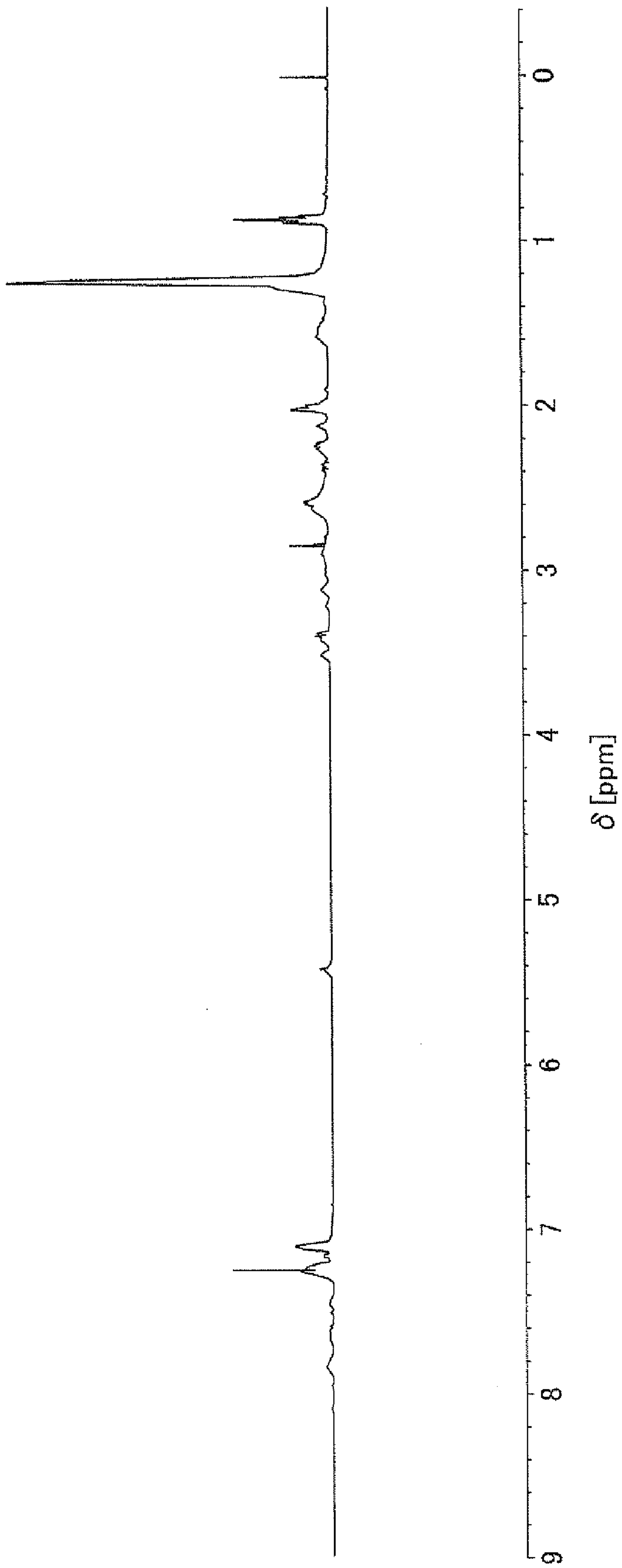

FIG.8

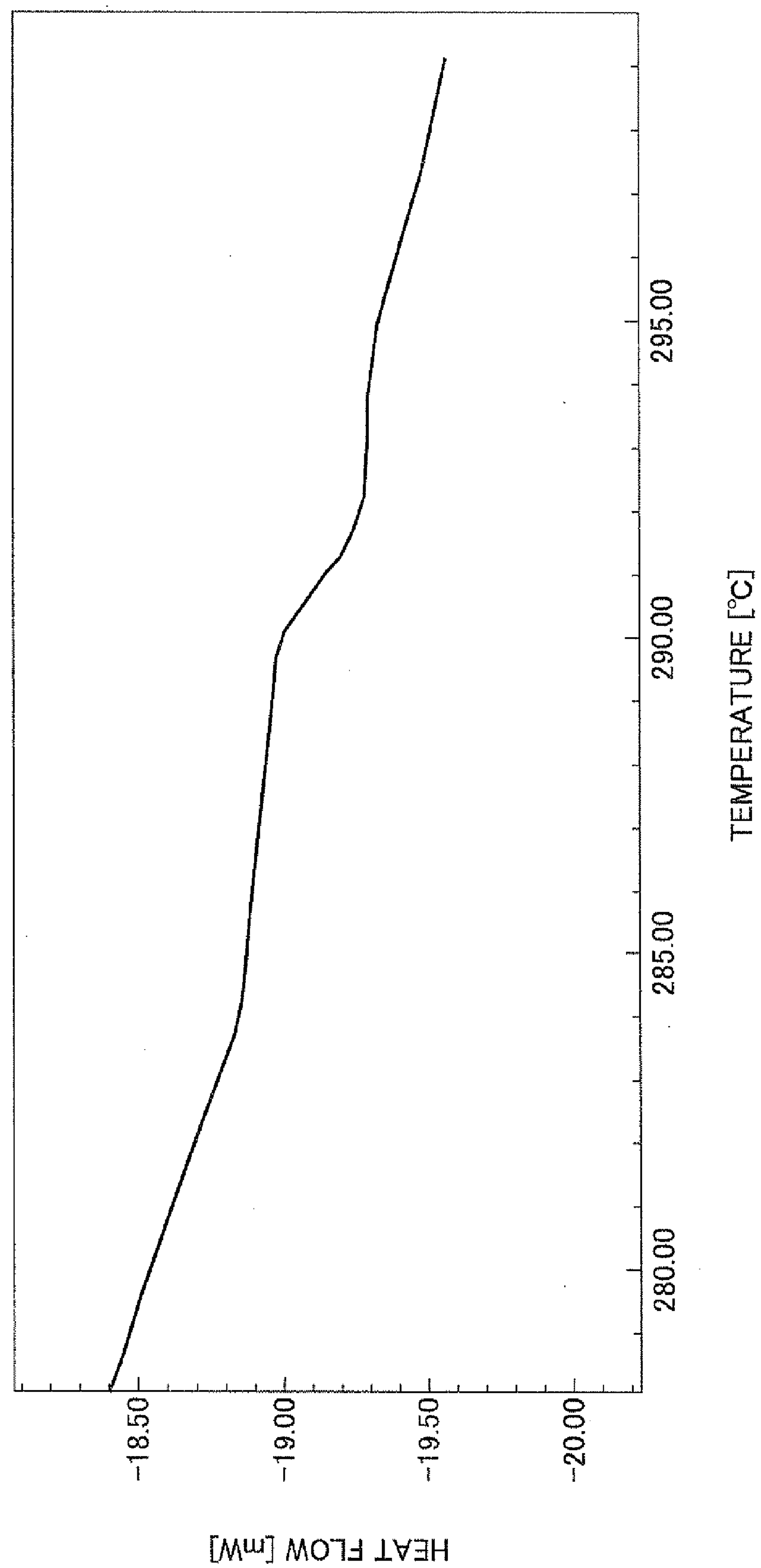

HEAT FLOW [mW]
−18.50
−19.00
−19.50
−20.00
280.00
285.00
290.00
295.00
TEMPERATURE [°C]

FIG.9

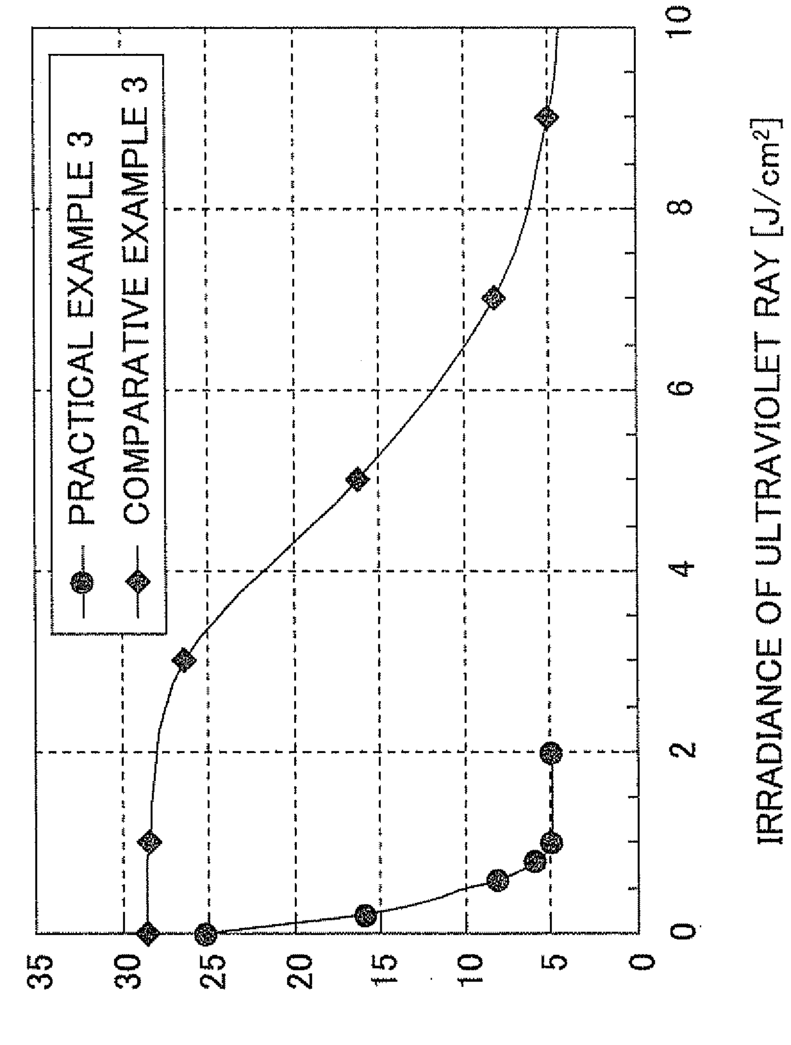
PRACTICAL EXAMPLE 3
COMPARATIVE EXAMPLE 3
CONTACT ANGLE [°]
IRRADIANCE OF ULTRAVIOLET RAY [J/cm2]
0
5
10
15
20
25
30
35
0
2
4
6
8
10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008041951 A
- JP 11140186 A
- JP 2011129010 A